# EUROPÄISCHE PATENTANMELDUNG

(11) **EP 4 576 179 A1**
(43) Veröffentlichungstag der Anmeldung: **25.06.2025**
(21) Anmeldenummer: 23217883.0
(22) Anmeldetag: 19.12.2023
(51) Int. Cl.: H01L 21/67

(54) **TROCKNUNGSVORRICHTUNG FÜR EINE HALBLEITERSCHEIBE**

(71) Anmelder: Siltronic AG, 81677 München (DE)
(72) Erfinder: Möckel, Bertram, 09599 Freiberg (DE); Franke, Jonny, 09575 Eppendorf (DE); Steglich, Stefanie, 01796 Pirna (DE)
(74) Vertreter: Hasenhütl, Eva

(57) **Zusammenfassung**

Die Erfindung betrifft eine Trocknungsvorrichtung, welche dazu ausgebildet ist, wenigstens eine darin an einer Trägereinheit (10) temporär angeordnete, benetzte Halbleiterscheibe (200) während wenigstens eines Trocknungsprozesses zu trocknen, wobei die Trocknungsvorrichtung (100) eine Trocknungshaubeneinheit (110) umfasst. Die Trocknungshaubeneinheit (110) umfasst wenigstens ein transparentes Scheibenelement (111, 112, 113), welches dazu ausgebildet ist und derart an der Trocknungshaubeneinheit (110) angeordnet ist, dass es in einem geschlossenen Zustand der Trocknungshaubeneinheit (110) von außerhalb der Trocknungsvorrichtung (100) über das wenigstens eine transparente Scheibenelement (111, 112, 113), über den gesamten wenigstens einen Trocknungsprozess betrachtet, eine im Wesentlichen uneingeschränkte optische Einsicht im Wesentlichen auf die gesamte Oberfläche der angeordneten Halbleiterscheibe (200), insbesondere für wenigstens einen Bediener, bereitstellt.

## Beschreibung

### Technisches Gebiet

Die Erfindung betrifft eine Trocknungsvorrichtung für eine Halbleiterscheibe und ein Verfahren zur Trocknung einer Halbleiterscheibe innerhalb der Trocknungsvorrichtung.

### Stand der Technik und technische Aufgabe

Bei bekannten Trocknungsprozessen bzw. Trocknungsvorrichtungen von benetzten Halbleiterscheiben, welche zuvor einen Reinigungsschritt durchlaufen haben, erfolgt eine Trocknung üblicherweise innerhalb einer Trocknungsvorrichtung, die am Ende einer Reinigungsstraße angeordnet und mit einem Gehäuse ausgebildet ist, das wenigstens überwiegend aus Kunststoff oder Edelstahl ausgebildet ist. Nach der Trocknung ist dann üblicherweise vorgesehen, dass jede Halbleiterscheibe mit weiteren, den Trocknungsprozess (seriell oder parallel) durchlaufenden Halbleiterscheiben einer vorgebbaren Menge in einer temporär an der Trocknungsvorrichtung angedockten Kassetteneinheit maschinell abgelegt wird. Diese Kassetteneinheit wiederum wird dann üblicherweise maschinell oder manuell an einen folgenden Prozessschritt (beispielsweise Analysestation) für die Halbleiterscheibe(n) der vorgebbaren Menge übergeben.

Zu diesem Zeitpunkt liegt dem Bediener jedoch keinerlei Information darüber vor, ob die Prozessführung bzw. die Prozessparameter an der Trocknungsvorrichtung überhaupt korrekt eingestellt und an die konkreten Erfordernisse für die benetzten und zu trocknenden Halbleiterscheiben angepasst waren, mit anderen Worten, ob die eingestellten Prozessparameter während des Trocknungsprozesses zu vollständig getrockneten Halbleiterscheibenoberflächen (mit anderen Worten ohne nicht-getrocknete(m) Bereich(e) an der Oberfläche) der Halbleiterscheiben geführt haben.

Denn bei den auf einen Reinigungsschritt folgenden Trocknungsprozess für benetzte Halbleiterscheiben innerhalb der hierfür bereitgestellten Trocknungsvorrichtungen ist bekannt, dass es zu uneinheitlichen oder unvollständigen Trocknungsprozessen der Halbleiterscheibe kommen kann.

Dies äußert sich dann in negativer Weise an einem oder mehreren mit dem freien Auge erkennbaren verbleibenden, nicht erfolgreich getrockneten Bereich(en), im Folgenden nicht-getrockneten Bereich(en), auf der Oberfläche der Halbleiterscheibe. Gründe hierfür können vielfältig sein. Unter anderem kann der nicht-getrocknete Bereich eine Folge sein aus:
- Zugesetzten Löcher einer IPA-Spraybar der Trocknungsvorrichtung,
- Änderung in den Zu- und Abluftbedingungen der Trocknungsvorrichtung,
- Änderungen von Differenzdrücken zwischen verschiedenen Anlagenbereichen der Trocknungsvorrichtung, usw.

Derartige Fehler können dem Bediener dann wie oben beschrieben überhaupt erst zu einem späteren Zeitpunkt an einer anderen Prozessstation optisch bzw. durch geeignete Messverfahren zugänglich gemacht werden (insbesondere in einer eigenen Inspektionsstation), wenn derartige Analysen überhaupt vorgesehen sind.

Selbst wenn eine nachgelagerte Inspektionsstation vorgesehen ist, können durch eine Trocknungsqualtitätsanalyse der Halbleiteroberflächen infolge zusätzlicher Handlingsabläufe in der Inspektionsstation, Partikel auf die Oberfläche der Halbleiterscheibe aufgebracht werden, die wiederum durch einen weiteren Reinigungsschritt (gefolgt von einem weiteren Trocknungsschritt) entfernt werden müssen, was wiederum in zeitlicher (folglich wirtschaftlicher) Hinsicht nachteilig für die gesamte Fertigungskette ist. Zudem liegen in diesem Zustand der Analyse bzw. Begutachtung der Halbleiterscheibe zwangsläufig viele für die Trocknung relevante Parameter nicht in dem realen Prozessfenster der komplett geschlossenen Trocknungsvorrichtung vor. Um diese für die Trocknung relevanten Parameter wieder zu justieren und einen stabilen Trocknungsprozess einzustellen ist es notwendig, einen Teil der Trocknungsvorrichtung (die Trocknungshaubeneinheit) temporär zu entfernen. Nur so ist es möglich, den Trocknungsprozess unmittelbar zu beobachten. Die für die Trocknung relevanten Parameter entsprechen aber in diesem Zustand des Trockners nicht denen eines geschlossenen Systems. Es kann daher vorkommen, dass dieses Vorgehen erst nach mehreren Versuchen zu dem gewünschten Trocknungserfolg (einer zuvor erfolgreich gereinigten Halbleiterscheibe) führt.

Der vorliegenden Erfindung liegt daher die objektive, technische Aufgabe zu Grunde, auf einfache Weise ein Trocknungsverfahren und eine Trocknungsvorrichtung für eine zuvor gereinigte (und dementsprechend benetzte) Halbleiterscheibe bereitzustellen, welche die oben genannten Nachteile nicht oder zumindest in geringerem Ausmaß aufweisen und welche insbesondere ohne zeitliche Einbußen für den Fertigungsprozess und ohne qualitative Einbußen für die Halbleiterscheibe auskommt.

Gelöst wird die Aufgabe durch eine Trocknungsvorrichtung mit einer Trocknungshaubeneinheit nach Anspruch 1, sowie durch ein Verfahren zur Trocknung einer Halbleiterscheibe nach Anspruch 9.

### Beschreibung der Erfindung

Der Erfindung liegt hierbei die technische Lehre zugrunde bzw. die Erfindung hat erkannt, dass man auf einfache Weise die eben beschriebenen zeitlichen Einbußen im Trocknungsprozess und qualitativen Einbußen der Halbleiterscheibe überwinden kann, indem man bei dem Trocknungsprozess eine Trocknungsvorrichtung bereitstellt, welche statt der konventionell vorgesehenen Trocknungshaubeneinheit in Form einer blickdichten Trocknerhaube (z.B. aus Edelstahl) eine Trocknungshaubeneinheit mit wenigstens einem integrierten, transparenten Scheibenelement vorsieht, welches eine optische Inspektion durch den Bediener (oder einer anderen für die Inspektion beauftragte Person als Bediener) unmittelbar während des eigentlichen Trocknungsprozess erlaubt bzw. bereitstellt. Mit anderen Worten hat die Erfindung erkannt, dass man durch das Vorsehen dieses wenigstens einen transparenten Scheibenelements an entsprechenden Stellen an der Trocknungshaubeneinheit die Zeit des Trocknungsprozesses, während der sich die Halbleiterscheibe in der geschlossenen Vorrichtung befindet, dafür nützen kann und die vorgegebene Trocknungszeit (z.B. im Bereich von 20 s bis 120 s bei einem Einzelscheibenprozess, bei zeitlich parallelen Prozessen (Batchprozessen; z.B. 50 Halbleiterscheiben pro Batch bis zu ca. 12 min) ausreicht, simultan den Fortschritt der Trocknung durch das wenigstens eine transparente Scheibenelement optisch zu inspizieren und Rückstände von nicht-getrockneten Bereichen zu erkennen (welche ein Indiz für eine inkorrekte, aktuelle Prozessführung sind), ohne dass die Halbleiterscheibe überhaupt aus der Trocknungsvorrichtung entfernt werden muss, d.h. die Halbleiterscheibe bleibt bei der Inspektion unter realen Prozessbedingungen. Bei Bedarf kann dann gleich in den Trocknungsprozess korrigierend über den Bediener eingegriffen werden, d.h. insbesondere durch Änderung der Prozessparameter (wie Druckparameter, Druckkaskade, Konzentrationsgradient, Geschwindigkeit der Halbleiterscheibe während des Trocknungsprozesses, Beschleunigung der Halbleiterscheibe während des Trocknungsprozesses) unmittelbar angepasst werden und insbesondere durch einen angepassten Trocknungsprozess einer erfolgreichen Trocknung wenigstens einer nächsten Halbleiterscheibe im zeitlich folgenden Trocknungsprozess dienen und/oder eine Änderung im Sinne einer Verlängerung der aktuellen Trocknungszeit des aktuellen Trocknungsprozesses vorzunehmen, um ggf. unmittelbar auf eine erfolgreiche Trocknungsqualität der aktuell zu trocknenden Halbleiterscheibe(n) innerhalb der Trocknungsvorrichtung hinzuwirken. Mit der erfindungsgemäßen Trocknungsvorrichtung in Verbindung mit dem erfindungsgemäßen Trocknungsverfahren kann also bei Trocknungsproblemen eine schnellere und effektivere Nach-Justage geeigneter Prozessparameter unter realen Prozessbedingungen ermöglicht werden, die in Reaktion auf die ermöglichte, simultane optische Begutachtung der Halbleiterscheibe(n) durch das wenigstens eine transparente Scheibenelement initiiert wird.

Weiterhin kann durch den Einsatz des erfindungsgemäßen Verfahrens an der erfindungsgemäßen Trocknungsvorrichtung die Partikelperformance verbessert werden.

Zusätzlich werden bei Geometriemessverfahren durch nicht-getrocknete Bereiche Messartefakte erzeugt, die zu falschen Aussagen bzgl. der geometrischen Eigenschaften der Halbleiterscheibe führen. Das wiederum führt zu Problemen bzgl. der Einstellung von Prozessparametern, die die Halbleiterscheibengeometrie beim Polieren beeinflussen. Durch die Vermeidung beider Effekte ist es damit möglich, Ausfälle zu minimieren und die Scheibenausbeute zu steigern.

Die Erfindung hat insbesondere erkannt, dass bei der Verwendung der bereitgestellten Trocknungshaubeneinheit mit wenigstens einem transparenten Scheibenelement die reguläre Trocknungszeit (wie sie bei konventionellen Trocknungsprozessen mit konventionellen, blickdichten Trocknungshaubeneinheiten vorgesehen ist) ausreicht, um eine Inspektion zu beiden Seiten der Halbleiterscheibe zu ermöglichen. Hierfür werden auch vorzugsweise die Abstände zwischen positionierten Halbleiterscheibe und der Trocknungsscheibeneinheit, insbesondere in Bezug auf das wenigstens eine transparente Scheibenelement, vergleichsweise gering gehalten und das Scheibenelement (oder die Scheibenelemente) vorzugsweise derart angeordnet, dass über den gesamten Trocknungsprozess betrachtet sämtliche für die Inspektion wesentlichen Abschnitte der Halbleiterscheibe, insbesondere im Wesentlichen die gesamte Halbleiterscheibe, einsehbar und damit inspezierbar wird (diese gänzliche Einsehbarkeit wird insbesondere im Zusammenspiel des wenigstens einen transparenten Scheibenelements mit den konventionellen, geführten Bewegungen der Halbleiterscheibe innerhalb der Trocknungsvorrichtung ermöglicht). Hierfür ist dank des Zusammenspiels der inneren Prozessführung und der Anordnung der transparenten Scheibenelemente eine einzige Person ausreichend für die vollständige Inspektion während des Trocknungsprozesses.

Ein weiterer Vorteil der Erfindung liegt also auch darin, dass der grundsätzliche konstruktive innere Aufbau der Trocknungsvorrichtung nicht verändert werden muss, sondern lediglich die erfindungsgemäße Trocknungshaubeneinheit an ihr vorgesehen sein muss, sodass die Vorteile für die Prozessführung und die gewünschte Trocknungsqualtität der Halbleiterscheiben über einen Bediener realisierbar werden.

Gemäß einem ersten Aspekt betrifft die Erfindung daher eine Trocknungsvorrichtung, welche dazu ausgebildet ist, wenigstens eine darin an einer Trägereinheit temporär angeordnete, benetzte Halbleiterscheibe während wenigstens eines Trocknungsprozesses, insbesondere unter Ausnutzung des Marangonieffekts, zu trocknen, wobei die Trocknungsvorrichtung eine Trocknungshaubeneinheit umfasst. Die Trocknungshaubeneinheit umfasst hierbei wenigstens ein transparentes Scheibenelement, welches dazu ausgebildet ist und derart an der Trocknungshaubeneinheit angeordnet ist, dass es in einem geschlossenen Zustand der Trocknungshaubeneinheit (bzw. in einem geschlossenen Zustand der Trocknungsvorrichtung) von außerhalb der Trocknungsvorrichtung über das wenigstens eine Scheibenelement, über den gesamten wenigstens einen Trocknungsprozess betrachtet, eine im Wesentlichen uneingeschränkte optische Einsicht im Wesentlichen auf die gesamte Oberfläche der angeordneten Halbleiterscheibe, insbesondere für wenigstens einen Bediener, bereitstellt.

Hiermit können die oben beschrieben Nachteile aus dem Stand der Technik in vollem Umfang überwunden und die Vorteile, wie sie oben im Zusammenhang mit der Erfindung beschrieben wurden, in vollem Umfang und auf einfache Weise erzielt werden.

Die erfindungsgemäße Trocknungsvorrichtung mit der erfindungsgemäßen Trocknungshaubeneinheit eignet sich vorzugsweise für einen Trocknungsprozess unter Ausnutzung des bekannten Marangonieffekts. Es ist allerdings auch möglich, die erfindungsgemäße Trocknungshaubeneinheit für einen HF/O₃₋ Trocknungsprozess einzusetzen, insbesondere wenn die Trocknungshaubeneinheit als Kunststoffrahmenstruktur mit wenigstens einem transparenten Scheibenelement ausgebildet ist.

Bei bevorzugten Varianten ist die Trocknungsvorrichtung vorzugsweise derart ausgebildet, dass während eines Trocknungsprozesses mehr als eine Halbleiterscheibe in der Trocknungsvorrichtung zeitgleich angeordnet ist (insbesondere unter Verwendung einer Badanlage für mehrere z.B. bis zu 50 Halbleiterscheiben).

Vorzugsweise ist die Trocknungshaubeneinheit dazu ausgebildet, sich während wenigstens eines Trocknungsprozesses einer innerhalb der Trocknungshaubenvorrichtung angeordneten Halbleiterscheibe in einem geschlossenen Zustand an der Trocknungsvorrichtung zu befinden, wobei die Trocknungshaubeneinheit weiterhin dazu ausgebildet sein kann, einen geöffneten Zustand zu ermöglichen, der beispielsweise eine Justage der Komponenten oder der wenigstens einen Halbleiterscheibe, oder eine Entnahme der Halbleiterscheibe(n) oder Wartung der innenliegenden Komponenten der Vorrichtung erlaubt.

Bei bevorzugten Varianten kann die Trocknungshaubeneinheit im Wesentlichen dünnwandig und/oder schalenförmig ausgebildet sein und das wenigstens eine transparente Scheibenelement in die Schale integriert sein, insbesondere in einen Schalenteil einer Haube der Trocknungshaubeneinheit integriert sein.

Grundsätzlich kann die Form der Trocknungshaubeneinheit beliebig gestaltet sein, solange die Funktion erfüllt wird, um die oben beschriebenen Vorteile in Verbindung mit der Erfindung zu erzielen. Bei weiteren bevorzugten Varianten ist jedoch vorzugsweise vorgesehen, dass die Trocknungshaubeneinheit eine Haube umfasst, welche im Querschnitt entlang ihrer Längsachse betrachtet im Wesentlichen die geometrische Form eines Ellipsenabschnitts, insbesondere einer Viertelellipse, beschreibt, wobei die Haube wenigstens zwei transparente Scheibenelemente umfassen kann, die an unterschiedlich geometrisch ausgerichteten Haubensegmenten angeordnet sein können. Eine derartige geometrische Ausgestaltung für die Trocknungshaubeneinheit ist besonders vorteilhaft, da sie an die geführte Bewegung der wenigstens einen Halbleiterscheibe über die Trägereinheit innerhalb der Trocknungsvorrichtung während des Trocknungsprozesses optimiert angepasst ist (translatorische Bewegung und Schwenkbewegung entlang der Längsachse) und damit ein geringer Abstand zwischen Halbleiterscheibe und der "Deckelfläche" der Trocknungshaubeneinheit vorgesehen ist. Wenn eben diese "Deckelfläche" als ein transparentes Scheibenelement ausgebildet ist, ist ein geringer Abstand besonders nützlich für die optische Begutachtung der wenigstens einen Halbleiterscheibe (bzw. wird die Begutachtung begünstigt).

Bei weiteren bevorzugten Varianten kann im Wesentlichen die gesamte Trocknungshaubeneinheit als Haube ausgebildet sein.

Bei weiteren bevorzugten Varianten kann die Haube wenigstens vier Haubensegmente umfassen, wobei
(i) ein erstes Haubensegment, welches im Wesentlichen die Form eines elliptischen Zylindermantelabschnitts aufweisen kann und als Art Deckelfläche der Haube ausgebildet sein kann, und
(ii) ein zweites Haubensegment, welches im Wesentlichen die Form eines Rechtecks aufweisen kann und die Haube auf der Seite des erhöhten Randes des ersten Haubensegments abschließen kann, und
(iii) ein drittes und ein viertes Haubensegment jeweils im Wesentlichen die Form eines Ellipsenabschnitts, insbesondere einer Viertelellipse, aufweisen kann,
wobei vorzugsweise in wenigstens zwei der wenigstens vier Haubensegmente jeweils ein transparentes Scheibenelement integriert ist.

Bei weiteren bevorzugten Varianten kann die Haube wenigstens teilweise, oder an allen Haubensegmenten rahmenartig aufgebaut sein. Hierbei ist die Rahmenstruktur vorzugsweise mit einem elektrisch leitfähigen Material sowie das wenigstens eine transparente Scheibenelement der Haube mit einem elektrisch leitfähigen Material, insbesondere Polycarbonat ESD antistatisch, ausgebildet.

Bei weiteren bevorzugten Varianten kann hierbei das erste Haubensegment rahmenartig, insbesondere aus Edelstahl oder Kunststoff, ausgebildet sein, und ein erstes, transparentes Scheibenelement, insbesondere ausgebildet als elektrisch leitfähiges transparentes Material, beispielsweise Polycarbonat ESD antistatisch, darin angeordnet sein, und das zweite Haubensegment rahmenartig, insbesondere aus Edelstahl oder Kunststoff, ausgebildet sein, und ein zweites, transparentes Scheibenelement, insbesondere ausgebildet als elektrisch leitfähiges transparentes Material, beispielsweise Polycarbonat ESD antistatisch, darin angeordnet sein. Weiterhin kann bei dieser bevorzugten Variante das dritte Haubensegment rahmenartig, insbesondere aus Edelstahl oder Kunststoff, ausgebildet sein, und ein drittes, transparentes Scheibenelement, insbesondere ausgebildet als elektrisch leitfähiges transparentes Material, beispielsweise Polycarbonat ESD antistatisch, darin angeordnet sein, und das vierte Haubensegment vollflächig, insbesondere aus Edelstahl oder Kunststoff, ausgebildet sein. Alternativ dazu kann das vierte Haubensegment rahmenartig, insbesondere aus Edelstahl oder Kunststoff, ausgebildet sein, und ein viertes, transparentes Scheibenelement, insbesondere ausgebildet als elektrisch leitfähiges transparentes Material, beispielsweise Polycarbonat ESD antistatisch, darin angeordnet sein kann, und das dritte Haubensegment hingegen vollflächig, insbesondere aus Edelstahl oder Kunststoff, ausgebildet sein.

Eine besonders einfach herzustellende, jedoch für den Bedarf einer ausreichenden optischen Einsicht effektive Ausführung ergibt sich also vorzugsweise mit drei transparenten Scheibenelementen, insbesondere bei einer Kombination dreier transparenten Scheibenelemente aus dem oben beschriebenen ersten, zweiten und dritten transparenten Scheibenelement oder dem oben beschriebenen ersten, zweiten und vierten transparenten Scheibenelement.

Bei weiteren bevorzugten Varianten kann die Geometrie der Trocknungshaubeneinheit derart ausgestaltet sein, dass die lichten Abstände zwischen der innerhalb der Trocknungsvorrichtung an der Trägereinheit positionierten Halbleiterscheibe und wenigstens zweier transparenter Scheibenelemente, gering gehalten sind.

Weiterhin können die wenigstens zwei transparenten Scheibenelemente der Haube an unterschiedlich geometrisch ausgerichteten Haubensegmenten angeordnet sein, sodass in einfacher Weise von außerhalb für den Bediener eine optische Einsichtnahme über den gesamten Trocknungsprozess betrachtet für sämtliche für die Inspektion wesentlichen Abschnitte der Halbleiterscheibe, insbesondere im Wesentlichen die gesamte Halbleiterscheibe, welche während des wenigstens einen Trocknungsprozesses innerhalb der Trocknungsvorrichtung über die Trägereinheit eine geführte Bewegung vollführt, ermöglicht wird.

Bei weiteren bevorzugten Varianten kann das wenigstens eine transparente Scheibenelement aus Kunststoff oder aus Plexiglas bestehen.

Bei weiteren bevorzugten Varianten kann das wenigstens eine transparente Scheibenelement aus elektrisch leitfähigem Material, insbesondere Polycarbonat ESD antistatisch, ausgebildet sein. Zusätzlich oder alternativ kann im Wesentlichen die gesamte Trocknungshaubeneinheit aus dem wenigstens einen transparenten Scheibenelement aufgebaut sein, welches aus elektrisch leitfähigem Material, insbesondere Polycarbonat ESD antistatisch, ausgebildet sein kann.

Bei weiteren bevorzugten Varianten kann das wenigstens eine transparente Scheibenelement dicht fixiert, und insbesondere lösbar fixiert, an der Trocknungshaubeneinheit, insbesondere an einem rahmenartigen Segment einer Haube der Trocknungshaubeneinheit, angeordnet sein. Zusätzlich oder alternativ kann die Trocknungshaubeneinheit, insbesondere eine Haube der Trocknungshaubeneinheit, wenigstens teilweise rahmenartig aufgebaut sein, wobei diese Rahmenstruktur aus einem elektrisch leitfähigen Material bestehen kann.

Bei weiteren bevorzugten Varianten kann das wenigstens eine transparente Scheibenelement innerhalb eines zugeordneten, rahmenartigen Haubensegments einer Haube der Trocknungshaubeneinheit angeordnet sein und mit dem zugeordneten, rahmenartigen Haubensegment eine monolithische Einheit bilden.

Gemäß einem zweiten Aspekt betrifft die Erfindung ein Verfahren zur Trocknung einer Halbleiterscheibe innerhalb der erfindungsgemäßen Trocknungsvorrichtung (oder in Kombination mit einer oder mehrerer ihrer vorteilhaften Varianten), nachdem die Halbleiterscheibe wenigstens einen Reinigungsschritt durchlaufen hat, wobei
- während wenigstens eines Trocknungsprozesses die Oberfläche der wenigstens einen benetzten Halbleiterscheibe, insbesondere im Wesentlichen die gesamte Oberfläche, insbesondere unter Ausnutzung des Marangoni-Effekts, getrocknet wird, und
- während des wenigstens einen Trocknungsprozesses der Trocknungsfortschritt und die Trocknungsqualität optisch über eine optische Einsichtnahme in die Trocknungsvorrichtung von außerhalb der Trocknungsvorrichtung über das wenigstens eine transparente Scheibenelement durch wenigstens einen Bediener inspiziert wird.

Hiermit können die oben beschrieben Nachteile aus dem Stand der Technik in vollem Umfang überwunden und die Vorteile, wie sie weiter oben im Zusammenhang mit der Erfindung beschrieben wurden, in vollem Umfang und auf einfache Weise erzielt werden.

Bei vorteilhaften Varianten kann dem wenigstens einen Trocknungsprozess eine vorgebbare Trocknungszeit zugeordnet sein, wobei die vorgebbare Trocknungszeit im Wesentlichen der vorgebbaren Trocknungszeit eines Vergleichstrocknungsprozesses entspricht, während welchem die wenigstens eine Halbleiterscheibe in einer Trocknungsvorrichtung mit blickdichter Trocknungshaubeneinheit getrocknet wird.

Hat beispielsweise ein Bediener während der Begutachtung während des Trocknungsprozesses keine nicht-getrockneten Bereiche an der Oberfläche der wenigstens einen Halbleiterscheibe festgestellt, entspricht zwar die Trocknungszeit im Wesentlichen der Trocknungszeit eines Vergleichstrocknungsprozesses, während welchem eine Halbleiterscheibe in einer Trocknungsvorrichtung mit blickdichter Trocknungshaubeneinheit getrocknet wird; allerdings weist der Trocknungsprozess im Vergleich zu bekannten Prozessen bzw. Vergleichsprozessen (POR) den Vorteil auf, dass durch die simultane Begutachtung des Trocknungsfortschritts und der Trocknungsqualität unmittelbar während des Trocknungsprozesses im Wesentlichen sämtliche, auf die Trocknung bezogene Inspektionsprozesse nach der Entnahme der Halbleiterscheibe entfallen und somit absolut gesehen für den gesamten Herstellungsprozess der Halbleiterscheibe Herstellungszeit je Halbleiterscheibe eingespart werden kann.

Bei vorteilhaften Varianten kann eine abschließende Inspektion und abschließende Beurteilung über den Trocknungsfortschritt und die Trocknungsqualität, insbesondere über die Beurteilung, ob wenigstens ein nicht-getrockneter Bereich spätestens bei Ablauf der vorgegebenen Trocknungszeit auf der Oberfläche der wenigstens einen Halbleiterscheibe verblieben ist, ausschließlich in einem geschlossenen Zustand der Trocknungshaubeneinheit (bzw. in einem geschlossenen Zustand der Trocknungsvorrichtung) mit der darin in der Trägereinheit angeordneten Halbleiterscheibe über die optische Einsichtnahme, insbesondere durch den wenigstens einen Bediener, von außen über das wenigstens eine transparente Scheibenelement erfolgen.

Bei weiteren vorteilhaften Varianten kann der Bediener zur Einsichtnahme der im Wesentlichen vollständigen Oberfläche der Halbleiterscheibe örtlich während des Trocknungsprozesses wenigstens zwischen zwei Positionen wechseln, um eine Einsichtnahme über wenigstens zwei unterschiedliche, insbesondere drei, transparente Scheibenelemente vorzunehmen.

Wie oben ausführlich beschrieben bietet die erfindungsgemäße Trocknungsvorrichtung den Vorteil, dass dank des wenigstens einen transparenten Scheibenelements an der Trocknungshaubeneinheit der Bediener eine uneingeschränkte Einsicht in die Oberflächen der wenigstens einen Halbleiterscheibe während des Trocknungsprozess erlangt und der Bediener ausgehend von dieser Einsicht eine Beurteilung über die Trocknungsqualität und den Trocknungsfortschritt vornehmen kann.

In Abhängigkeit des Ergebnisses seiner Beurteilung können dem Bediener unterschiedliche Reaktionsszenarien zur Verfügung stehen.

Sollte der Bediener keine oder unterhalb einer vorgebbaren Toleranzschwelle liegende nicht-getrocknete Bereiche an der wenigstens einen Halbleiterscheibe vorfinden, ist der Trocknungsprozess an der Trocknungsvorrichtung in diesem Stadium für diese wenigstens eine Halbleiterscheibe erfolgreich abgeschlossen und sie kann dann an die nächste Prozessstation mittels der Kassetteneinheit übergeben werden.

Sollte der Bediener hingegen wenigstens ein nicht-getrockneter Bereich (insbesondere oberhalb einer vorgebbaren Toleranzschwelle) an der wenigstens einen Halbleiterscheibe feststellen, kann dieser im Wesentlichen unmittelbar durch Vornahme einer Anpassung wenigstens eines Prozessparameters an der Trocknungsvorrichtung regulierend eingreifen, um für den weiteren Prozessablauf bei den zeitlich folgenden Trocknungsprozessen den zeitlich folgend eingebrachten Halbleiterscheiben stabile, zu vollständig getrocknete Halbleiterscheiben führende, Prozessbedingungen bereitzustellen.

Hierzu kann wenigstens einer aus folgenden Prozessparametern an der Trocknungsvorrichtung verändert eingestellt werden: Druckparameter, Druckkaskade, Konzentrationsgradient, Geschwindigkeit der Halbleiterscheibe während des Trocknungsprozesses, Beschleunigung der Halbleiterscheibe während des Trocknungsprozesses.

Vorzugsweise wird dann nach Beendigung des wenigstens einen Trocknungsprozesses die wenigstens eine Halbleiterscheibe dann in der temporär an der Trocknungsvorrichtung angedockten Kassetteneinheit angeordnet und nach wenigstens teilweiser Befüllung dieser Kassetteneinheit die Kassetteneinheit der nächsten Prozessstation, manuell oder maschinell, übergeben.
(i) Hierbei kann die Anpassung wenigstens eines Prozessparameters den Schritt umfassen, dass der Bediener die vorgegebene Trocknungszeit des aktuellen Trocknungsprozesses um einen Verlängerungszeitabschnitt über eine Einstellung an der Trocknungsvorrichtung verlängert einstellt oder einen weiteren Trocknungsprozess für die aktuell wenigstens eine Halbleiterscheibe startet, wenn die Beurteilung über die optische Gestalt des wenigstens einen nicht-getrockneten Bereichs auf der wenigstens einen Halbleiterscheibe während des Trocknungsprozesses durch den Bediener über die optische Einsichtnahme über das wenigstens eine transparente Scheibenelement derart ausfällt, dass durch einen direkten Eingriff für eine zeitliche Verlängerung des aktuellen Trocknungsprozesses, insbesondere um einem Wert in einem Bereich von 1 s bis 60 s, zu erwarten ist, dass der wenigstens eine nicht-getrocknete Bereich an der wenigstens einen Halbleiterscheibe spätestens bei Ablauf des Verlängerungszeitabschnitts durch den Trocknungsprozess im Wesentlichen vollständig entfernt wird.
(ii) Zusätzlich oder alternativ zu (i) kann die wenigstens eine Halbleiterscheibe innerhalb der Kassetteneinheit als nächste Prozessstation einem erneuten Reinigungsschritt an der Reinigungsstraße vor der Trocknungsvorrichtung in Form der nächsten Prozessstation zugeführt werden, wenn die zeitlich vorgelagerte Beurteilung des Bedieners an der Trocknungsvorrichtung für diese wenigstens eine Halbleiterscheibe über die optische Einsichtnahme über das wenigstens eine transparente Scheibenelement ergab, dass die optische Gestalt des wenigstens einen nicht-getrockneten Bereichs auf der wenigstens einen Halbleiterscheibe während des Trocknungsprozesses oder während des um einen Verlängerungszeitabschnitt verlängerten Trocknungsprozesses derart ausgeprägt ist, dass ein erneuter Reinigungsschritt mit nachgelagertem erneuten Trocknungsprozess innerhalb der Trocknungsvorrichtung erforderlich ist.

### Kurzbeschreibung der Figur

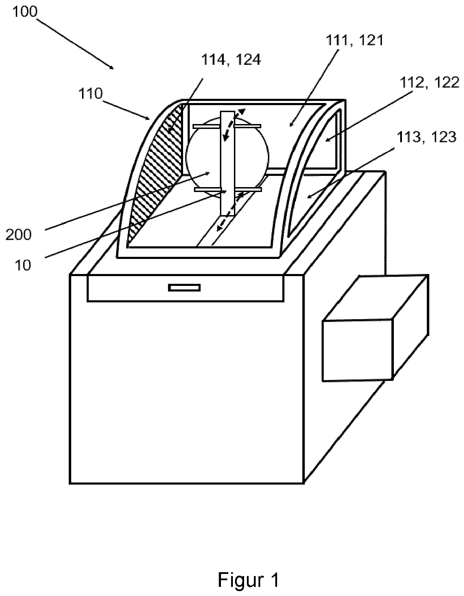

**Figur 1** zeigt eine schematische dreidimensionale Darstellung einer erfindungsgemäßen Trocknungsvorrichtung 100 mit Halbleiterscheibe 200 mit einer erfindungsgemäßen Trocknungshaubeneinheit 110 mit drei transparenten Scheibenelementen 111, 112, 113 zur vollständigen Einsichtnahme der Oberfläche der Halbleiterscheibe 200 während des Trocknungsprozesses durch einen Bediener.

### Bevorzugte Ausführungsform der erfindungsgemäßen Vorrichtung und des erfindungsgemäßen Verfahrens

Im Folgenden und mit Verweis auf Figur 1 wird eine bevorzugte Ausführungsform der erfindungsgemäßen Trocknungsvorrichtung 100 für eine zu trocknende Halbleiterscheibe 200 mit einer erfindungsgemäßen Trocknungshaubeneinheit 110 mit drei transparenten Scheibenelementen 111, 112, 113 zur vollständigen Einsichtnahme der Oberfläche der Halbleiterscheibe 200 während des Trocknungsprozesses während des erfindungsgemäßen Verfahrens durch einen Bediener beschrieben.

Die Trocknungsvorrichtung 100 ist dazu ausgebildet, die darin an einer Trägereinheit 10 temporär angeordnete, benetzte Halbleiterscheibe 200 unter Ausnutzung des bekannten Marangonieffekts während eines Trocknungsprozesses zu trocknen, nachdem die Halbleiterscheibe 200 einen Reinigungsschritt durchlaufen hat. Die Trocknungsvorrichtung 100 umfasst die Trocknungshaubeneinheit 110.

Die Trocknungshaubeneinheit 110 ist dünnwandig und schalenförmig ausgebildet und umfasst eine Haube, welche im Querschnitt entlang ihrer Längsachse betrachtet die geometrische Form eines Ellipsenabschnitts, insbesondere im Wesentlichen einer Viertelellipse, beschreibt.

Die Haube umfasst drei transparente Scheibenelemente 111, 112, 113, die an unterschiedlich geometrisch ausgerichteten Haubensegmenten 121, 122, 123 angeordnet sind, wobei die Haube vier Haubensegmente 121, 122, 123, 124 umfasst:
- ein erstes Haubensegment 121, welches im Wesentlichen die Form eines elliptischen Zylindermantelabschnitts aufweist und als Art Deckelfläche der Haube ausgebildet ist,
- ein zweites Haubensegment 122, welches im Wesentlichen die Form eines Rechtecks aufweist und die Haube auf der Seite des erhöhten Randes des ersten Haubensegments 123 abschließt, und
ein drittes 123 und ein viertes 124 Haubensegment, welches jeweils die Form eines Ellipsenabschnitts aufweist.

Das erste Haubensegment 121 ist rahmenartig, aus Edelstahl, ausgebildet, und das erste, transparente Scheibenelement 111 ist darin angeordnet.

Das zweite Haubensegment 122 ist rahmenartig, aus Edelstahl, ausgebildet, und das zweite, transparente Scheibenelement 112 ist darin angeordnet.

Das dritte Haubensegment 123 ist rahmenartig, aus Edelstahl, ausgebildet, und das dritte, transparente Scheibenelement 113 ist darin angeordnet. Das vierte Haubensegment 124 ist vollflächig, aus Edelstahl, ausgebildet.

Drei der vier Haubensegmente sind also rahmenartig aufgebaut. Diese Rahmenstruktur der Haube und das vierte, vollflächige Haubensegment sind hierbei aus elektrisch leitfähigem Material ausgebildet (Edelstahl) und die drei transparenten Scheibenelemente sind ebenfalls aus elektrisch leitfähigem Material (in Form von Polycarbonat ESD antistatisch) ausgebildet.

Wie in Figur 1 ersichtlich, ist die Geometrie der Trocknungshaubeneinheit 110 derart ausgestaltet, dass die lichten Abstände zwischen der innerhalb der Trocknungsvorrichtung 100 an der Trägereinheit 10 positionierten Halbleiterscheibe 200 und der drei transparente Scheibenelemente 111, 112, 113 jeweils gering gehalten sind. Die drei transparenten Scheibenelemente 111, 112, 113 sind an unterschiedlich geometrisch ausgerichteten Haubensegmenten 121, 122, 123 derart angeordnet, dass über den gesamten Trocknungsprozess betrachtet sämtliche für die Inspektion wesentlichen Abschnitte der Halbleiterscheibe 200, im Wesentlichen die gesamte Halbleiterscheibe 200, welche während des Trocknungsprozesses innerhalb der Trocknungsvorrichtung 100 über die Trägereinheit 10 eine geführte Bewegung vollführt, uneingeschränkt für den Bediener optisch für die Begutachtung der Oberfläche auf nicht-getrocknete Bereiche einsehbar ist. Hierdurch kann der Bediener während des Trocknungsprozesses den Trocknungsfortschritt und die Trocknungsqualität optisch überwachen.

Eine abschließende Inspektion und abschließende Beurteilung über den Trocknungsfortschritt und die Trocknungsqualität, besonders über die Beurteilung, ob wenigstens ein nicht-getrockneter Bereich spätestens bei Ablauf der vorgegebenen Trocknungszeit auf der Oberfläche der Halbleiterscheibe 200 verblieben ist, kann hierbei in vorteilhafter Weise ausschließlich in einem geschlossenen Zustand der Trocknungshaubeneinheit 110 (bzw. in einem geschlossenen Zustand der Trocknungsvorrichtung 100) mit der darin in der Trägereinheit 10 angeordneten Halbleiterscheibe 200 erfolgen.

Die transparenten Scheibenelemente 111, 112, 113 sind dicht fixiert und lösbar fixiert an der Trocknungshaubeneinheit 110, konkret innerhalb des zugehörigen, rahmenartigen Haubensegments, angeordnet.

In dem vorliegenden Ausführungsbeispiel hat der Bediener während der Begutachtung während des Trocknungsprozesses keine nicht-getrockneten Bereiche an der Oberfläche der Halbleiterscheibe 200 festgestellt. Die Trocknungszeit entspricht daher im Wesentlichen der Trocknungszeit eines Vergleichstrocknungsprozesses, während welchem eine Halbleiterscheibe 200 in einer Trocknungsvorrichtung mit blickdichter Trocknungshaubeneinheit 110 getrocknet wird, allerdings bei dem bevorzugten Ausführungsbeispiel im Vergleich zu bekannten Prozessen bzw. Vergleichsprozessen (POR) mit dem oben beschriebenen Vorteil, dass durch die simultane Begutachtung des Trocknungsfortschritts und der Trocknungsqualität unmittelbar während des Trocknungsprozesses einige, auf die Trocknung bezogene Inspektionsprozesse (wie sie eingangs beschrieben wurden) nach der Entnahme der Halbleiterscheibe 200 entfallen können (und somit absolut gesehen für den gesamten Herstellungsprozess der Halbleiterscheibe 200 Herstellungszeit je Halbleiterscheibe 200 reduziert werden kann).

Mit anderen Worten ist im konkreten Fall die ohnehin vorgegebene Trocknungszeit für die abschließende Inspektion über die Beurteilung der Trocknungsqualität durch den Bediener ausreichend.

Es konnte damit auch festgestellt werden, dass die Prozessparameter für den konkreten Trocknungsprozess korrekt eingestellt sind.

Nach Beendigung des Trocknungsprozesses wird die Halbleiterscheibe 200 in einer temporär an der Trocknungsvorrichtung 100 angedockten Kassetteneinheit (rein schematisch angedeutet in Figur 1) angeordnet, und nach Befüllung der Kassetteneinheit mit weiteren Halbleiterscheiben, die den Trocknungsprozess an der Trocknungsvorrichtung 100 durchlaufen haben, wird die Kassetteneinheit der nächsten Prozessstation (hier einer Polierstation) manuell übergeben.

## Patentansprüche

1. Trocknungsvorrichtung, welche dazu ausgebildet ist, wenigstens eine darin an einer Trägereinheit (10) temporär angeordnete, benetzte Halbleiterscheibe (200) während wenigstens eines Trocknungsprozesses zu trocknen, wobei die Trocknungsvorrichtung (100) eine Trocknungshaubeneinheit (110) umfasst,
**dadurch gekennzeichnet, dass**
• die Trocknungshaubeneinheit (110) wenigstens ein transparentes Scheibenelement (111, 112, 113) umfasst, welches dazu ausgebildet ist und derart an der Trocknungshaubeneinheit (110) angeordnet ist, dass es in einem geschlossenen Zustand der Trocknungshaubeneinheit (110) von außerhalb der Trocknungsvorrichtung (100) über das wenigstens eine transparente Scheibenelement (111, 112, 113), über den gesamten wenigstens einen Trocknungsprozess betrachtet, eine im Wesentlichen uneingeschränkte optische Einsicht im Wesentlichen auf die gesamte Oberfläche der angeordneten Halbleiterscheibe (200), insbesondere für wenigstens einen Bediener, bereitstellt.

2. Trocknungsvorrichtung nach Anspruch 1, wobei die Trocknungshaubeneinheit (110) im Wesentlichen dünnwandig und/oder schalenförmig ausgebildet ist und das wenigstens eine transparente Scheibenelement (111, 112, 113) in die Schale integriert ist, insbesondere in einen Schalenteil einer Haube der Trocknungshaubeneinheit (110) integriert ist.

3. Trocknungsvorrichtung nach Anspruch 1 oder 2, wobei die Trocknungshaubeneinheit (110) eine Haube umfasst, insbesondere als Haube (110) ausgebildet ist, welche im Querschnitt entlang ihrer Längsachse betrachtet im Wesentlichen die geometrische Form eines Ellipsenabschnitts, insbesondere einer Viertelellipse, beschreibt, wobei die Haube (110) wenigstens zwei transparente Scheibenelemente (111, 112, 113) umfasst, die an unterschiedlich geometrisch ausgerichteten Haubensegmenten (121, 122, 123) angeordnet sind.

4. Trocknungsvorrichtung nach Anspruch 3, wobei die Haube wenigstens vier Haubensegmente (121, 122, 123, 124) umfasst, wobei
ein erstes Haubensegment,(121), welches im Wesentlichen die Form eines elliptischen Zylindermantelabschnitts aufweist und als Art Deckelfläche der Haube ausgebildet ist, und
ein zweites Haubensegment (122), welches im Wesentlichen die Form eines Rechtecks aufweist und die Haube auf der Seite des erhöhten Randes des ersten Haubensegments abschließt, und
ein drittes (123) und ein viertes (124) Haubensegment jeweils im Wesentlichen die Form eines Ellipsenabschnitts, insbesondere einer Viertelellipse, aufweisen,
wobei
in wenigstens zwei der wenigstens vier (121, 122, 123, 124) Haubensegmente jeweils ein transparentes Scheibenelement integriert ist.

5. Trocknungsvorrichtung nach Anspruch 4, wobei
das erste Haubensegment (121) rahmenartig, insbesondere aus Edelstahl oder Kunststoff, ausgebildet ist, und ein erstes, transparentes Scheibenelement (111) darin angeordnet ist, und
das zweite Haubensegment (122) rahmenartig, insbesondere aus Edelstahl oder Kunststoff, ausgebildet ist, und ein zweites, transparentes Scheibenelement (112) darin angeordnet ist,
und
• das dritte Haubensegment (123) rahmenartig, insbesondere aus Edelstahl oder Kunststoff, ausgebildet ist, und ein drittes, transparentes Scheibenelement (113) darin angeordnet ist, und das vierte Haubensegment (124) vollflächig, insbesondere aus Edelstahl oder Kunststoff, ausgebildet ist,
oder
• das vierte Haubensegment rahmenartig, insbesondere aus Edelstahl oder Kunststoff, ausgebildet ist, und ein viertes, transparentes Scheibenelement darin angeordnet ist, und das dritte Haubensegment vollflächig, insbesondere aus Edelstahl oder Kunststoff, ausgebildet ist.

6. Trocknungsvorrichtung nach einem der vorherigen Ansprüche, wobei
• die Geometrie der Trocknungshaubeneinheit (110) derart ausgestaltet ist, dass die lichten Abstände zwischen der innerhalb der Trocknungsvorrichtung (100) an der Trägereinheit (10) positionierten Halbleiterscheibe (200) und wenigstens zweier transparenter Scheibenelemente (111, 112, 113), gering gehalten sind, und
• die wenigstens zwei transparenten Scheibenelemente (111, 112, 113) an unterschiedlich geometrisch ausgerichteten Haubensegmenten (121, 122, 123) derart angeordnet sind, dass über den gesamten Trocknungsprozess betrachtet sämtliche für die Inspektion wesentlichen Abschnitte der Halbleiterscheibe (200), insbesondere im Wesentlichen die gesamte Halbleiterscheibe(200), welche während des wenigstens einen Trocknungsprozesses innerhalb der Trocknungsvorrichtung (100) über die Trägereinheit (10) eine geführte Bewegung vollführt, optisch einsehbar sind.

7. Trocknungsvorrichtung nach einem der vorherigen Ansprüche, wobei das wenigstens eine transparente Scheibenelement (111, 112, 113) aus elektrisch leitfähigem Material, insbesondere Polycarbonat ESD antistatisch, ausgebildet ist, und/oder wobei im Wesentlichen die gesamte Trocknungshaubeneinheit (110) aus dem wenigstens einen transparenten Scheibenelement aufgebaut ist, welches aus elektrisch leitfähigem Material, insbesondere Polycarbonat ESD antistatisch, ausgebildet ist.

8. Trocknungsvorrichtung nach einem der vorherigen Ansprüche, wobei das wenigstens eine transparente Scheibenelement (111, 112, 113) dicht fixiert an der Trocknungshaubeneinheit (110), insbesondere an einem rahmenartigen Haubensegment einer Haube der Trocknungshaubeneinheit (110), angeordnet ist, und/oder die Trocknungshaubeneinheit, insbesondere eine Haube der Trocknungshaubeneinheit, wenigstens teilweise rahmenartig aufgebaut ist, wobei diese Rahmenstruktur aus einem elektrisch leitfähigen Material besteht.

9. Verfahren zur Trocknung einer Halbleiterscheibe (200) innerhalb einer Trocknungsvorrichtung (100) nach einem der Ansprüche 1 bis 8, nachdem die wenigstens eine Halbleiterscheibe (200) wenigstens einen Reinigungsschritt durchlaufen hat, wobei
• während wenigstens eines Trocknungsprozesses die Oberfläche der wenigstens einen benetzten Halbleiterscheibe (200), insbesondere im Wesentlichen die gesamte Oberfläche, getrocknet wird, und
• während des wenigstens einen Trocknungsprozesses der Trocknungsfortschritt und die Trocknungsqualität optisch über eine optische Einsichtnahme in die Trocknungsvorrichtung (100) von außerhalb der Trocknungsvorrichtung über das wenigstens eine transparente Scheibenelement (111, 112, 113) durch wenigstens einen Bediener inspiziert wird.

10. Verfahren nach Anspruch 9, wobei dem wenigstens einen Trocknungsprozess eine vorgebbare Trocknungszeit zugeordnet ist, wobei die vorgebbare Trocknungszeit im Wesentlichen der vorgebbaren Trocknungszeit eines Vergleichstrocknungsprozesses entspricht, während welchem wenigstens eine Halbleiterscheibe (200) in einer Trocknungsvorrichtung (100) mit blickdichter Trocknungshaubeneinheit (110) getrocknet wird.

11. Verfahren nach Anspruch 9 oder 10, wobei eine abschließende Inspektion und abschließende Beurteilung über den Trocknungsfortschritt und die Trocknungsqualität, insbesondere über die Beurteilung, ob wenigstens ein nicht-getrockneter Bereich spätestens bei Ablauf der vorgegebenen Trocknungszeit auf der Oberfläche der Halbleiterscheibe (200) verblieben ist, ausschließlich in einem geschlossenen Zustand der Trocknungshaubeneinheit (110) mit der darin in der Trägereinheit (10) angeordneten wenigstens einen Halbleiterscheibe (200) über die optische Einsichtnahme durch den wenigstens einen Bediener von außen über das wenigstens eine transparente Scheibenelement (111, 112, 113) erfolgt.

12. Verfahren nach einem der Ansprüche 9 bis 11, wobei der wenigstens eine Bediener zur Einsichtnahme der im Wesentlichen vollständigen Oberfläche der wenigstens einen Halbleiterscheibe (200) örtlich während des Trocknungsprozesses wenigstens zwischen zwei Positionen wechselt, um eine Einsichtnahme über wenigstens zwei unterschiedliche, insbesondere drei, transparente Scheibenelemente (111, 112, 113) vorzunehmen.

13. Verfahren nach einem der Ansprüche 9 bis 12, wobei
• während des wenigstens einen Trocknungsprozesses bei Feststellung wenigstens eines nicht-getrockneten Bereichs durch den wenigstens einen Bediener an der wenigstens einen Halbleiterscheibe (200), dieser im Wesentlichen unmittelbar durch Vornahme einer Anpassung wenigstens eines Prozessparameters an der Trocknungsvorrichtung (100) regulierend eingreift, um für den weiteren Prozessablauf bei den zeitlich folgenden Trocknungsprozessen den zeitlich folgend eingebrachten Halbleiterscheiben (200) stabile, zu vollständig getrocknete Halbleiterscheiben führende, Prozessbedingungen bereitzustellen, wobei wenigstens einer aus folgenden Prozessparametern verändert eingestellt wird: Druckparameter, Druckkaskade, Konzentrationsgradient, Geschwindigkeit der Halbleiterscheibe während des Trocknungsprozesses, Beschleunigung der Halbleiterscheibe während des Trocknungsprozesses,
• nach Beendigung des wenigstens einen Trocknungsprozesses die wenigstens eine Halbleiterscheibe (200) in einer temporär an der Trocknungsvorrichtung (100) angedockten Kassetteneinheit angeordnet wird, und
• nach wenigstens teilweiser Befüllung der Kassetteneinheit mit wenigstens einer Halbleiterscheibe (200) die Kassetteneinheit der nächsten Prozessstation, manuell oder maschinell, übergeben wird.

14. Verfahren nach Anspruch 13, wobei während des wenigstens einen Trocknungsprozesses:
• die Anpassung wenigstens eines Prozessparameters den Schritt umfasst, dass der Bediener die vorgegebene Trocknungszeit des aktuellen Trocknungsprozesses um einen Verlängerungszeitabschnitt über eine Einstellung an der Trocknungsvorrichtung (100) verlängert einstellt oder einen weiteren Trocknungsprozess für die aktuell wenigstens eine Halbleiterscheibe (200) startet, wenn die Beurteilung über die optische Gestalt des wenigstens einen nicht-getrockneten Bereichs auf der wenigstens einen Halbleiterscheibe (200) während des Trocknungsprozesses durch den Bediener über die optische Einsichtnahme über das wenigstens eine transparente Scheibenelement (111, 112, 113) derart ausfällt, dass durch einen direkten Eingriff für eine zeitliche Verlängerung des aktuellen Trocknungsprozesses, insbesondere um einem Wert in einem Bereich von 1 s bis 60 s, zu erwarten ist, dass der wenigstens eine nicht-getrocknete Bereich an der wenigstens einen Halbleiterscheibe (200) spätestens bei Ablauf des Verlängerungszeitabschnitts durch den Trocknungsprozess im Wesentlichen vollständig entfernt wird.

15. Verfahren nach Anspruch 13 oder 14, wobei die wenigstens eine Halbleiterscheibe (200) innerhalb der Kassetteneinheit als nächste Prozessstation einem erneuten Reinigungsschritt an der Reinigungsstraße vor der Trocknungsvorrichtung (100) in Form der nächsten Prozessstation zugeführt wird, wenn die zeitlich vorgelagerte Beurteilung des Bedieners an der Trocknungsvorrichtung (100) für diese wenigstens eine Halbleiterscheibe (200) über die optische Einsichtnahme über das wenigstens eine transparente Scheibenelement (111, 112, 113) ergab, dass die optische Gestalt des wenigstens einen nicht-getrockneten Bereichs auf der wenigstens einen Halbleiterscheibe (200) während des Trocknungsprozesses oder während des um einen Verlängerungszeitabschnitt verlängerten Trocknungsprozesses derart ausgeprägt ist, dass ein erneuter Reinigungsschritt mit nachgelagertem erneuten Trocknungsprozess innerhalb der Trocknungsvorrichtung (100) erforderlich ist.
